# EUROPEAN PATENT APPLICATION

(11) **EP 2 725 625 A1**
(43) Date of publication of application: **30.04.2014**
(21) Application number: 12803488.1
(22) Date of filing: 21.06.2012
(51) Int. Cl.: H01L 31/042, B32B 7/02

(54) **REAR SURFACE PROTECTIVE SHEET FOR SOLAR CELL**

(30) Priority: 23.06.2011 JP 2011139237
(71) Applicant: Toyo Aluminium Kabushiki Kaisha, Osaka-shi, Osaka 541-0056 (JP)
(72) Inventor: TANAKA, Saya, Osaka-shi Osaka 541-0056 (JP); MAEDA, Daisuke, Osaka-shi Osaka 541-0056 (JP); HASHIZUME, Yoshiki, Osaka-shi Osaka 541-0056 (JP)
(74) Representative: Nieuwenhuys, William Francis
(86) International application number: PCT/JP2012/065821
(87) International publication number: WO 2012/176828

(57) **Abstract**

The present invention provides a rear-surface protective sheet for solar cells, the rear-surface protective sheet having a function of suppressing temperature increase in solar cells. The present invention provides a rear-surface protective sheet for solar cells that is disposed on a rear surface of a solar cell, comprising at least one heat conversion layer containing a heat conversion filler having a function of converting thermal energy to vibrational energy to consume the thermal energy,
the heat conversion filler in the heat conversion layer having a density of 3 to 35 g/m².

## Description

### Technical Field

The present invention relates to a rear-surface protective sheet for solar cells that is disposed on the rear-surface of a solar cell, in particular to a rear-surface protective sheet for solar cells that has a function of suppressing temperature increase in a solar cell.

### Background Art

Solar cells are mainly installed on rooftops of buildings. Because of direct heat from sunlight and heat from the roof, the temperature of the solar cell sometimes reaches 70°C or more. It is said that the conversion efficiency of crystalline silicon-based solar cells decreases by about 0.4%/°C as the temperature increases. Further, a rear-surface protective sheet for solar cells is typically applied on the rear surface of a solar cell, and the resulting laminate is generally referred to as a solar cell module.

Methods have been proposed to suppress temperature increase in solar cells.

Patent Literature 1 is directed to a heat-releasing membrane for a solar cell module, and a solar cell module including the heat-releasing membrane. Specifically, Patent Literature 1 discloses that providing a coating material layer having heat dissipation (heat-releasing membrane) on the rear surface of a solar cell decreases the module temperature. To provide the coating material layer with weather resistance, an overcoating or a weather-resistant film is required, and a material that does not hinder heat dissipation must be selected.

Patent Literature 2 is directed to a mist spraying device. Specifically, Patent Literature 2 discloses spraying mist to a solar cell module by a mist spray system using a heat exchange paint to decrease the module temperature. The rear-surface protective sheet for solar cells and the solar cell disclosed in Patent Literature 2, do not themselves have a function of suppressing temperature increase.

The heat exchange paint mentioned above is a coating material containing a heat conversion molecule that has a function of converting thermal energy into vibrational energy to consume the thermal energy. This coating material is commercially available from Arbar Industrial Co., Ltd., under the product names of Tough Coat D42, Tough Coat D47, etc., and also referred to as a heat-consuming coating material.

### Citation List

### Patent Literature

PTL 1: JP2007-12967A
PTL 2: JP2010-78264A

### Summary of Invention

### Technical Problem

An object of the present invention is to provide a rear-surface protective sheet for solar cells that has a function of suppressing temperature increase in a solar cell.

### Solution to Problem

The present inventors conducted extensive research to attain the above object and found that the use of a rear-surface protective sheet for solar cells that has a specific heat conversion layer can attain the above object. The present invention was thus accomplished.

Specifically, the present invention relates to the following rear-surface protective sheets for solar cells.
1. A rear-surface protective sheet for solar cells that is disposed on a rear surface of a solar cell, comprising at least one heat conversion layer containing a heat conversion filler having a function of converting thermal energy to vibrational energy to consume the thermal energy,
   the heat conversion filler in the heat conversion layer having a density of 3 to 35 g/m².
2. The rear-surface protective sheet for solar cells according to Item 1, wherein the rear-surface protective sheet comprises a resin film substrate, and the heat conversion layer is formed on one side or both sides of the resin film substrate.
3. The rear-surface protective sheet for solar cells according to Item 1, wherein the rear-surface protective sheet comprises at one side of the resin film substrate a heat-sealing layer that is to be bonded to the rear surface of the solar cell, and a weather-resistant film at the other side, and the heat conversion layer is formed on one side or both sides of the resin film substrate.
4. The rear-surface protective sheet for solar cells according to any one of Items 1 to 3, wherein the heat conversion layer is formed by applying and drying a coating material containing the heat conversion filler.
5. The rear-surface protective sheet for solar cells according to any one of Items 1 to 4, wherein the heat-sealing layer comprises a component that can be heat-sealed with an ethylene acetic vinyl copolymer.

The rear-surface protective sheet for solar cells of the present invention is explained in detail below.

The rear-surface protective sheet for solar cells of the present invention is disposed on the rear surface of a solar cell. The rear-surface protective sheet includes a heat conversion layer containing a heat conversion filler that has a function of converting thermal energy into vibrational energy to consume the thermal energy. The heat conversion filler in the heat conversion layer has a density of 3 to 35 g/m².

The rear-surface protective sheet for solar cells of the present invention, having the features mentioned above, can suppress the temperature increase of a solar cell because the heat conversion filler in the heat conversion layer converts thermal energy into vibrational energy to thereby consume the thermal energy. It is desired that a coating film that suppresses temperature increase by using reflection or radiation of thermal energy be formed at the outermost layer; however, since the heat conversion layer used in the present invention can consume heat energy even when it is not formed as the outermost layer, the heat conversion layer of the present invention can be formed as an inner layer (a layer that is not exposed on the surface of the sheet). Further, a material that does not interfere with heat dissipation has been required for forming a weather-resistant film at the outermost layer; however, any of a wide variety of known weather-resistant films can be used in the present invention.

The known layer structure of a rear-surface protective sheet for solar cells is generally such that a heat-sealing layer (for adhering to the rear surface of a solar cell) is applied on a resin film substrate via an adhesive layer. A layer structure in which a weather-resistant film is applied on the other side of the resin film substrate via an adhesive layer is also known.

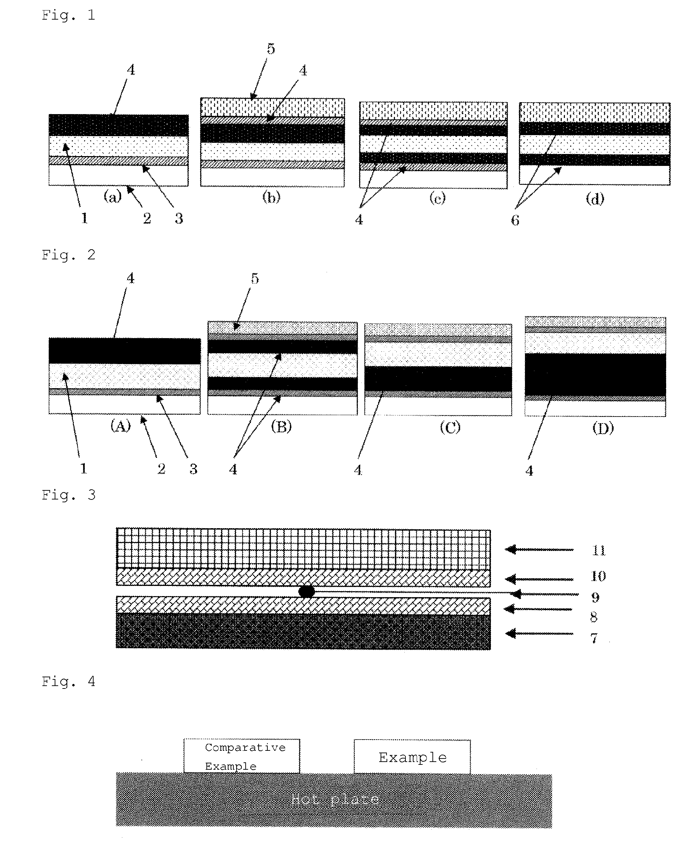

The heat conversion layer used in the present invention can be formed at any position as long as it does not hinder the adhesion of the rear surface of the solar cell and the rear-surface protective sheet for solar cells via the heat-sealing layer. The rear-surface protective sheet for solar cells of the present invention has, for example, layer structures (a) to (d) shown in Fig. 1.

In layer structure (a) of Fig. 1, heat-sealing layer 2 is formed on resin film substrate 1 via adhesive layer 3, and heat conversion layer 4 is formed on the other side of resin film substrate 1.

Layer structure (b) of Fig. 1 is the same as layer structure (a) of Fig. 1, except that weather-resistant film 5 is formed on the outer side of heat conversion layer 4 via adhesive layer 3. Such a formation of weather-resistant film 5 on the outermost layer can increase the scratch resistance of the rear-surface protective sheet for solar cells, and prevent or suppress damage to the heat conversion layer.

Layer structure (c) of Fig. 1 is the same as layer structure (b) of Fig. 1, except that heat conversion layer 4 formed on one side of resin film substrate 1 is formed on both sides of resin film substrate 1. Forming heat conversion layer 4 on only one side of resin film substrate 1 may curl the laminate during the formation of heat conversion layer 4. Such curling can be prevented or suppressed when heat conversion layer 4 is formed on both sides of resin film substrate 1 as in layer structure (c) of Fig. 1.

In layer structure (d) of Fig. 1, adhesive layer 3 and heat conversion layer 4 in layer structure (c) of Fig. 1 are combined into one layer (layer 6). In other words, layer 6 is a heat conversion layer and an adhesive layer. Layer 6 can be obtained by mixing the heat conversion filler used in the present invention with a composition for forming the adhesive layer in a manner such that the composition has a desired density, and forming a membrane.

Layer structures (a) to (d) are merely examples, and of course other layer structures can be used. The addition of the heat conversion filler to the resin film substrate or the weather-resistant film can impart the function of the heat conversion layer to these layers.

The resin film substrate, heat-sealing layer, adhesive layer, heat conversion layer, and weather-resistant film are explained in detail below.

### Resin Film Substrate

The resin film substrate is not limited. A wide variety of resin film substrates used for known rear-surface protective sheets for solar cells can be used. For example, it is possible to use resin film substrates made of polyethylene terephthalate, polyethylenenaphthalate, polypropylene, polyamide, polyimide, polycarbonate, polyacrylicnitrile, polycycloolefin, polyphenylene ether, etc.

As a substrate, it is possible to use metallic foil such as aluminum foil to increase thermal conductivity, thereby enhancing the heat conversion effect; however, it is necessary to make a hole in the rear-surface protective sheet for solar cells to draw out the electrode wires when the sheet is bonded to the solar cell. Since a metal-containing rear-surface protective sheet for solar cells may short-circuit the solar cell when the insulation is inadequate, the use of a resin film substrate as in the present invention is preferred. However, with adequate insulation, metallic foil such as aluminum foil can be used together with a resin film substrate, as required.

The thickness of the resin film substrate is not limited, and it is preferably 200 to 300 µm, and more preferably 100 to 250 µm. A resin film substrate that is too thin results in a low voltage resistance as a rear-surface protective sheet for solar cells. A resin film substrate that is too thick increases the weight of the rear-surface protective sheet for solar cells, and after being bonded to the rear surface of the solar cell, the sheet may peel off from the solar cell with long-term use.

### Heat-Sealing Layer

The heat-sealing layer is the surface layer (solar cell side) of the rear-surface protective sheet for solar cells, and is bonded to the solar-cell sealing material (which is disposed on the lowermost layer of the solar cell and typically includes an ethylene-vinyl acetate copolymer (EVA)). The heat-sealing layer is not limited as long as it adheres to the sealing material. The heat-sealing layer preferably includes a component that can be heat-sealed with EVA. In view of adhesion with EVA, it is preferred to use linear low-density polyethylene (0.910 to 0.940 g/cm³) as a matrix of the heat-sealing layer.

The heat-sealing layer preferably includes an inorganic-based ultraviolet ray absorber to prevent yellowing due to ultraviolet rays. Examples of the inorganic-based ultraviolet ray absorber include titanium oxide, zinc oxide, zirconium oxide, calcium carbonate, cerium oxide, aluminum oxide, silica, iron oxide, carbon, and the like. Of these, titanium oxide and carbon are preferred.

The ultraviolet ray absorber preferably has a mean particle diameter of 0.1 to 5 µm. Ultraviolet ray absorbers that have a mean particle diameter exceeding 5 µm result in poor dispersibility, making it impossible to obtain a uniform ultraviolet ray absorption effect. Ultraviolet ray absorbers that have a mean particle diameter of less than 0.1 µm are not favorable in terms of cost.

The ultraviolet ray absorber is preferably contained in an amount of 0.1 to 30 mass% to obtain a sufficient ultraviolet ray absorption effect and maintain good adhesion with the sealing agent, i.e., EVA. An ultraviolet ray absorber in an amount less than 0.1 mass% does not ensure a sufficient ultraviolet ray absorption effect and may result in yellowing due to ultraviolet rays. An ultraviolet ray absorber in an amount exceeding 30 mass% may decrease adhesion with EVA.

The ultraviolet ray transmission rate of the heat-sealing layer is preferably 20% or less. A heat-sealing layer with an ultraviolet ray transmission rate exceeding 20% may result in yellowing due to insufficient ultraviolet-ray absorption effect. Although the lower limit of the ultraviolet-ray transmission rate is not particularly limited, it is generally about 1%.

The thickness of the heat-sealing layer is not limited. The heat-sealing layer preferably has a thickness of 5 to 200 µm, and more preferably 30 to 180 µm to fully contain the ultraviolet ray absorber. A heat-sealing layer with a thickness less than 5 µm may not contain a sufficient amount of ultraviolet ray absorber.

### Adhesive Layer

The adhesive layer for adhering layers of the rear-surface protective sheet for solar cells is not limited. For example, layers can be bonded using a urethane-based adhesive according to a dry lamination method.

Examples of the urethane-based adhesive include two-component curable urethane-based adhesives, polyether urethane-based adhesives, polyester polyurethane polyol-based adhesives, etc. Of these, two-component curable urethane-based adhesives are preferred. The type and the thickness of the adhesive can be suitably determined according to the type of layer to be bonded.

### Heat Conversion Layer

The heat conversion layer includes a heat conversion filler (heat conversion molecule) that converts thermal energy into vibrational energy to thereby consume the thermal energy. Infrared radiation contained in sunrays, etc., is converted into thermal energy when spread to the heat conversion layer, and then dispersed and moved in the heat conversion layer; however, the infrared radiation is immediately converted to vibrational energy when it comes into contact with the heat conversion filler in the heat conversion layer. Most of heat energy is promptly consumed because the energy conversion occurs on the surface layer of the heat conversion filler. Therefore, the heat energy in the heat conversion layer is consumed without being accumulated. In the present invention, the heat conversion layer can also improve the voltage resistance of the rear-surface protective sheet for solar cells.

In the present invention, the density of the heat conversion filler in the heat conversion layer (the content density, i.e., the coating amount of the heat conversion filler) may be 3 to 35 g/m², and preferably 10 to 35 g/m². A heat conversion filler with a density of less than 3 g/m² may result in insufficient heat conversion efficiency. A heat conversion filler with a density exceeding 35 g/m² does not ensure heat conversion efficiency improvement commensurate with the content of the heat conversion filler. Accordingly, in the present invention, the heat conversion filler has a density of 3 to 35g/m².

The heat conversion layer is preferably formed by applying and drying a coating material containing the heat conversion filler. The coating material is referred to as a heat exchange paint (heat-consuming coating material), and is commercially available from Arbar Industrial Co., Ltd., under the product names of Tough Coat D42, Tough Coat D47, etc.

Tough Coat D42, mentioned above, is a two-component curable heat exchange paint in which the main agent contains an acrylic polyol resin and a heat conversion filler, and the curing agent contains isocyanate (HMDI: hexamethylene diisocyanate). Tough Coat D47 is an aqueous one-component curable heat exchange paint that contains a styrene acrylic ester copolymer resin, a thermoplastic urethane resin, and a heat conversion filler.

A heat conductive filler may be added to the heat conversion layer to increase the thermal conduction efficiency. Examples of the heat conductive filler include aluminum powder, nitriding aluminum, boron nitride, silicon oxide, aluminum oxide, magnesium oxide, etc. These heat conductive fillers can be used singly or as a mixture of two or more.

Although the thickness of the heat conversion layer is not limited, it is preferably 10 to 200 µm, more preferably 20 to 150 µm, and most preferably 50 to 100 µm. A heat conversion layer with a thickness less than 10 µm results in poor heat conversion efficiency, while a heat conversion layer with a thickness exceeding 200 µm does not ensure the heat conversion efficiency improvement commensurate with increase in film thickness. The heat conversion layer may be formed on one side or both sides of the resin film substrate, as described above. When the layer is formed on both sides of the substrate, it is preferable to form layers separately so that the total thickness is within the aforementioned range.

When the heat conversion layer plays a role of an adhesive layer, the heat conversion filler is added to a composition forming the adhesive layer in a desired density, and the resultant is used as a heat conversion layer and an adhesive layer.

### Weather-Resistant Film

The weather-resistant film is not limited. It is possible to use a wide variety of weather-resistant films used for known rear-surface protective sheets for solar cells. Examples of a film having weather resistance and electric insulation include polyester films such as polyethylenenaphthalate (PEN) and polyethylene terephthalate (PET); fluorine-based films such as polyvinylidene fluoride (PVDF), polyvinyl fluoride (PVF), and ethylenetetrafluoroethylene (ETFE); polyolefin films such as polyethylene and polypropylene; polystyrene films; polyamide films; polyvinylchloride films; polycarbonate films; polyacrylicnitrile films; polyimide films; and the like. In view of outdoor durability, hydrolysis-resistant PET can be preferably used.

Engineering plastics and fluororesins are other examples. Examples of the engineering plastics include polyacetal (POM), polyamide (PA), polycarbonate (PC), modified polyphenylene ether (m-PPE), polybutylene terephthalate (PBT), GF strengthening polyethylene terephthalate (GF-PET), ultra-high-molecular-weight polyethylene (UHPE), syndiotactic polystyrene (SPS), amorphism polyarylate (PAR), polysulfone (PSF), polyether sulfone (PES), polyphenylene sulfide (PPS), polyether ether ketone (PEEK), polyimide (PI), polyetherimide (PEI), polyphenylene ether (PPE), liquid crystal polymer (LCP), etc.

The weather-resistant film can be a single layer or multiple layers (laminated films). A single layer preferably has a thickness of 20 to 250 µm. Multiple layers are preferably a laminate including a film having excellent weather resistance and a film having excellent electric insulation. In the laminate, it is preferable to dispose the film with excellent electric insulation at the resin film substrate side and dispose the film with excellent weather resistance at the outermost layer. The film with excellent weather resistance is preferably a fluorine-based film with a thickness of 20 to 150 µm, and the film with excellent electric insulation is preferably a PET film with a thickness of 100 to 250 µm.

### Advantageous Effects of Invention

The rear-surface protective sheet for solar cells of the present invention can suppress the temperature increase of a solar cell because the heat conversion filler in the heat conversion layer converts thermal energy into vibrational energy to thereby consume the thermal energy. It is desired that a coating film that suppresses temperature increase by using reflection or radiation of thermal energy be formed at the outermost layer; however, since the heat conversion layer used in the present invention can consume heat energy even when it is not formed as the outermost layer, the heat conversion layer of the present invention can be formed as an inner layer (a layer that is not exposed on the surface of the sheet). Further, a material that does not interfere with heat dissipation has been required for forming a weather-resistant film at the outermost layer; however, any of a wide variety of known weather-resistant films can be used in the present invention.

### Brief Description of Drawings

Fig. 1 shows layer structures of the rear-surface protective sheets for solar cells of the present invention.
Fig. 2A shows the layer structure of the rear-surface protective sheets for solar cells prepared in Example 1 and Comparative Example 1. Fig. 2B shows the layer structure of the rear-surface protective sheets for solar cells prepared in Example 2 and Comparative Example 2. Fig. 2C shows the layer structure of the rear-surface protective sheets for solar cells prepared in Example 3 and Comparative Example 3. Fig. 2D shows the layer structure of the rear-surface protective sheets for solar cells prepared in Examples 4 to 6 and Comparative Examples 4 to 6.
Fig. 3 shows a simulated module used in Test Example 1.
Fig. 4 shows a heating device used in Test Example 1.
Fig. 5 shows a relation between the density (g/m²) of the heat conversion filler and the temperature decrease rate (%).

### Description of Embodiments

The present invention is explained in detail below with reference to Examples and Comparative Examples; however, the present invention is not limited to the Examples.

### Example 1

Heat exchange paint D-47 (produced by Arbar Industrial Co., Ltd.) was applied on one side of a polyester film (produced by Teijin Limited., 125 µm) in an amount of 100 µm. The content density of the heat conversion filler was 12 g/m². By using a dry laminating adhesive according to a dry lamination method, a linear low-density polyethylene film (produced by Tamapoly Co., Ltd., 50 µm) was bonded as a heat-sealing layer to be bonded to an EVA sealing material to the side on which the heat exchange paint was not applied. As the dry laminating adhesive, a polyurethane-based adhesive obtained by mixing Takelac A315 (100 parts by weight) and Takenate A50 (10 parts by weight) produced by Mitsui Chemicals, Inc., was used in an amount of 5 g/m² (solid). Thus, a rear-surface protective sheet for solar cells was produced.

### Example 2

Heat exchange paint D-47 (Arbar Industrial Co., Ltd.) was applied to each side of a polyester film (produced by Teijin Limited, 125 µm) in an amount of 50 µm. The content density of the heat conversion filler was 12 g/m². A PVF film (Tedlar produced by DuPont, 38 µm) was applied on one side as a layer providing weather resistance, and a linear low-density polyethylene film (produced by Tamapoly Co., Ltd., 50 µm) was applied on the other side as a heat-sealing layer to be bonded to an EVA sealing material by using a dry laminating adhesive according to a dry lamination method. As the dry laminating adhesive, a polyurethane-based adhesive obtained by mixing Takelac A315 (100 parts by weight) and Takenate A50 (10 parts by weight) produced by Mitsui Chemicals, Inc., was used in an amount of 5 g/m² (solid). Thus, a rear-surface protective sheet for solar cells was produced.

### Example 3

Heat exchange paint D-47 (produced by Arbar Industrial Co., Ltd.) was applied on one side of a polyester film (produced by Teijin Limited, 125 µm) in an amount of 100 µm. The content density of the heat conversion filler was 12 g/m². A PVF film (Tedlar produced by DuPont, 38 µm) was applied as a layer providing weather resistance on the side on which the heat exchange paint was not applied, and a linear low-density polyethylene film (produced by Tamapoly Co., Ltd., 50 µm) was applied as a heat-sealing layer to be bonded to an EVA sealing material by using a dry laminating adhesive according to a dry lamination method. As the dry laminating adhesive, a polyurethane-based adhesive obtained by mixing Takelac A315 (100 parts by weight) and Takenate A50 (10 parts by weight) produced by Mitsui Chemicals, Inc., was used in an amount of 5 g/m² (solid). Thus, a rear-surface protective sheet for solar cells was produced.

### Examples 4 to 6

Rear-surface protective sheets for solar cells were obtained in the same manner as in Example 3 except that the thickness of the heat conversion coating layer was changed to 10 µm, 200 µm, and 300 µm, respectively.

### Comparative Examples 1 to 6

Rear-surface protective sheets for solar cells were obtained in the same manner as in Examples 1 to 6 except that the heat conversion layer was not provided.

### Test Example 1 (Heating Test)

As shown in Fig. 3, glass, EVA, a thermocouple, EVA, and a sample were layered in this order (glass/EVA/thermocouple/EVA/sample), and a simulated module was made using a vacuum laminating machine (produced by NPC Incorporated.) (The slash indicates the lamination order.)

Rear-surface protective sheets for solar cells produced in Examples 1 to 6 and Comparative Examples 1 to 6 were used as samples.

As shown in Fig. 4, the sheets were placed on a hot plate so that the glass surfaces faced the hot plate. The actual temperature of each thermocouple was measured, and the maximum temperature difference between the temperature of each example and the temperature of its corresponding comparative example was checked.

Table 1 below shows the test results.

**Table 1**

| | Actual temperature (°C) | Maximum temperature difference (°C) |
|---|---|---|
| Example 1 | 64.1 | -1.4 |
| Example 2 | 65.7 | -1.8 |
| Example 3 | 59.6 | -0.6 |
| Example 4 | 67.5 | -0.5 |
| Example 5 | 66.1 | -2.8 |
| Example 6 | 67.3 | -3.0 |
| Comparative Example 1 | 65.5 | |
| Comparative Example 2 | 67.5 | |
| Comparative Example 3 | 60.2 | |
| Comparative Example 4 | 68.0 | |
| Comparative Example 5 | 68.9 | |
| Comparative Example 6 | 70.3 | |

As is clear from the results of Table 1, in the heat conversion layer-containing rear-surface protective sheets for solar cells of Examples 1 to 6, the actual temperature of each thermocouple was lower than that of the corresponding Comparative Examples 1 to 6. Thus, the sheets of Examples 1 to 6 can suppress a temperature increase in a solar cell.

### Test Example 2

A heat exchange paint including a heat conversion filler was applied on a steel plate and dried, and the surface was heated with an incandescent lamp. The relationship between the content density of the heat conversion filler and the temperature decrease rate was observed.

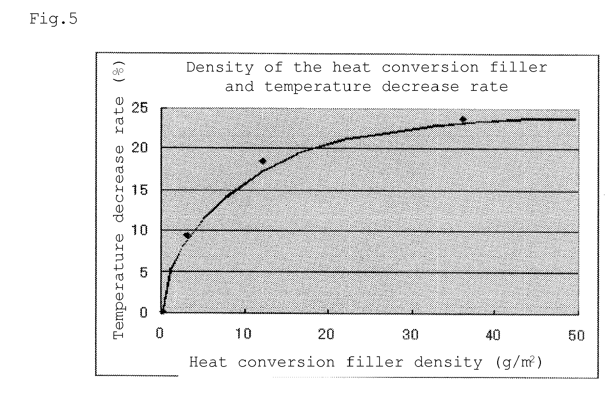

Fig. 5 shows the results. The results of Fig. 5 clearly indicate that a good temperature decrease rate was obtained when the content density of the heat conversion filler was 3 to 35 g/m².

1. Resin film substrate
2. Heat-sealing layer
3. Adhesive layer
4. Heat conversion layer
5. Weather-resistant film
6. Heat conversion layer and adhesive layer
7. Glass
8. EVA
9. Thermocouple
10. EVA
11. Sample

## Claims

1. A rear-surface protective sheet for solar cells that is disposed on a rear surface of a solar cell, comprising at least one heat conversion layer containing a heat conversion filler having a function of converting thermal energy to vibrational energy to consume the thermal energy,
the heat conversion filler in the heat conversion layer having a density of 3 to 35 g/m².

2. The rear-surface protective sheet for solar cells according to claim 1, wherein the rear-surface protective sheet comprises a resin film substrate, and the heat conversion layer is formed on one side or both sides of the resin film substrate.

3. The rear-surface protective sheet for solar cells according to claim 1, wherein the rear-surface protective sheet comprises at one side of the resin film substrate a heat-sealing layer that is to be bonded to the rear surface of the solar cell, and a weather-resistant film at the other side, and the heat conversion layer is formed on one side or both sides of the resin film substrate.

4. The rear-surface protective sheet for solar cells according to any one of claims 1 to 3, wherein the heat conversion layer is formed by applying and drying a coating material containing the heat conversion filler.

5. The rear-surface protective sheet for solar cells according to any one of claims 1 to 4, wherein the heat-sealing layer comprises a component that can be heat-sealed with an ethylene acetic vinyl copolymer.
